# FASCICULE DE BREVET EUROPEEN

(11) **EP 1 662 953 B1**
(45) Date de publication et mention de la délivrance du brevet: **24.01.2007**
(21) Numéro de dépôt: 04787299.9
(22) Date de dépôt: 02.09.2004
(51) Int. Cl.: A47J 36/02, C22C 19/07

(54) **SURFACE DE CUISSON FACILE A NETTOYER ET ARTICLE ELECTROMENAGER COMPORTANT UNE TELLE SURFACE**
LEICHT ZU REINIGENDE KOCHFLÄCHE UND ELEKTRISCHES HAUSHALTSGERÄT MIT DIESER
EASY-TO-CLEAN COOKING SURFACE AND ELECTRIC HOUSEHOLD APPLIANCE COMPRISING SAME

(30) Priorité: 11.09.2003 FR 0310679
(43) Date de publication de la demande: 07.06.2006
(73) Titulaire: SEB S.A., 69130 Ecully (FR)
(72) Inventeur: COUDURIER, Alain, F-73410 Albens (FR)
(74) Mandataire: Kiehl, Hubert
(86) Numéro de dépôt international: PCT/FR2004/002244
(87) Numéro de publication internationale: WO 2005/025394

(56) Documents cités:
- EP-A- 0 440 877
- CH-A- 516 006
- GB-A- 220 710
- US-A- 2 057 254
- US-A- 3 547 098
- US-A- 3 993 597

## Description

La présente invention concerne le domaine des articles destinés à la préparation et à la cuisson des aliments et plus particulièrement la surface de cuisson de ces articles en contact avec les aliments à traiter.

Depuis de nombreuses années, des efforts importants ont été développés afin de faciliter la préparation quotidienne des repas. Parmi les progrès notables, les revêtements à base de polymères fluorocarbonés en tant que revêtement adhésif dans les ustensiles de cuisine se sont rapidement développés depuis la fin des années 1950. De tels revêtements sont mondialement connus depuis que le procédé présenté dans le brevet FR 1120749 a permis une fixation sûre de tels revêtements sur des métaux divers, tel l'aluminium.

Le document GB 220 710 décrit un alliage pour une surface de cuisson d'aliment.

Toutefois, de tels revêtements restent fragiles. Ainsi, des astuces ont été développées afin de renforcer mécaniquement la couche sur son support. De nombreux brevets de perfectionnement décrivent des méthodes et moyens permettant d'accroître la résistance aux rayures de tels revêtements, en agissant sur le revêtement et/ou sur le substrat. Malgré tout, de tels revêtements restent sensibles à l'usage répété de matériaux métalliques aiguisés ou pointus, tels des couteaux ou fourchettes.

Parallèlement, des développements ont été menés sur des surfaces résistantes mécaniquement dont on a essayé d'améliorer la facilité de nettoyage. Des dépôts métalliques, tels le chromage sur inox, les quasi-cristaux, ou non métalliques (silicates,...) sont ainsi apparus. Les résultats restent toutefois décevants, notamment en comparaison avec les revêtements de type PTFE.

La présente invention vise à remédier aux inconvénients précités de l'art antérieur, en proposant une surface de cuisson aux caractéristiques améliorées de facilité de nettoyage, de résistance à la corrosion, tout en présentant une bonne tenue mécanique.

La présente invention est atteinte par une surface de cuisson d'aliment pour ustensile de cuisine ou appareil de cuisson, caractérisée en ce que cette surface de cuisson est un composé métallique cristallin contenant, en poids, au moins 50 % de cobalt et au moins 18 % de chrome.

Par l'expression « composé métallique », il faut entendre un composé constitué essentiellement de métaux en alliage, en excluant leur combinaison à l'oxygène, sauf sous forme de traces pouvant résulter du procédé de fabrication, mais non sciemment recherchées.

Les alliages métalliques à base de cobalt, tels les Alacrite^{®}, sont généralement connus pour leur résistance exceptionnelle à la corrosion (essentiellement par le chrome), et leur bonne résistance à l'usure (essentiellement par le cobalt). Ils sont essentiellement utilisés, en mécanique, en garnissage intérieur de paliers de pistons. Certaines nuances sont utilisées dans le domaine médical pour la réalisation d'implants et de prothèses.

D'une manière surprenante, il a été constaté, au cours d'essais, que des alliages, contenant une majorité de cobalt et de chrome, présentaient également des propriétés de facilité de nettoyage lorsque de telles surfaces étaient utilisées en tant que surface de cuisson et que des denrées alimentaires restaient accrochées à la surface, par exemple après une calcination des produits mis à cuire. Cette facilité de nettoyage peut être exprimée par la possibilité d'enlever facilement des éléments carbonisés sur la surface de cuisson.

Avantageusement, le composé métallique cristallin comporte au moins 5 % d'un ou plusieurs des métaux parmi : tungstène, nickel, molybdène. L'apport de ces matériaux permet principalement d'augmenter la dureté, ce qui confère une résistance accrue du revêtement, tout particulièrement aux chocs mécaniques.

De préférence, l'alliage comporte au moins 60 % de cobalt, au moins 25 % de chrome et au moins 5 % de molybdène.

Selon un premier mode de mise en oeuvre de l'invention, la surface de cuisson d'aliment pour ustensile de cuisine ou appareil de cuisson est obtenue par le dépôt d'une épaisseur appropriée du matériau métallique sur un substrat. Ce dépôt peut être réalisé par différents procédés. On peut citer notamment : projection thermique d'une poudre d'une granulométrie adéquate, dépôt par électrophorèse d'une poudre micro ou sub-micronique, pulvérisation cathodique d'une cible massive. Dans ce dernier cas la cible peut être obtenue par assemblage sur un substrat de cuivre d'une ou plusieurs tôles ou plaques de matériau ayant la composition recherchée, lesdites tôles ou plaques étant obtenues soit par frittage de poudre ou projection thermique de poudre, soit issues de coulée. D'une manière générale, toutes les techniques de dépôt physique en phase vapeur peuvent être utilisées. D'autres techniques, telles le compactage à chaud ou le dépôt par électrolyse peuvent également être utilisées.

Cette mise en oeuvre présente l'avantage d'utiliser peu de matière et de pouvoir ajuster une faible épaisseur de matériau sur le substrat en vue de réaliser la surface de cuisson.

Toutes ces techniques permettent, par ailleurs, d'obtenir des dépôts en forte cohésion avec le substrat sur lequel ils sont déposés. Les risques de décollement du dépôt au cours de l'utilisation sont ainsi minimisés.

Selon un second mode de mise en oeuvre de l'invention, la surface de cuisson d'aliment pour ustensile de cuisine ou appareil de cuisson est obtenue par assemblage d'une tôle métallique cristalline ayant la composition recherchée sur un substrat. Cette mise en oeuvre présente l'avantage de se rapprocher des mises en oeuvre connues d'assemblage des métaux, ce qui permet de pouvoir adapter des techniques connues sans développement spécifique important.

L'assemblage de la tôle sur le substrat peut être réalisé par l'une des techniques suivantes : colaminage, brasage, frappe à chaud, d'une manière connue en soi. Le placage par explosion peut également être envisagé.

Avantageusement, la tôle et le substrat subissent, après assemblage, une étape de mise en forme par emboutissage. Le substrat peut être composé d'une ou plusieurs tôle(s) métallique(s) des matériaux suivants : aluminium, inox, fonte, acier, cuivre.

D'autres avantages issus des essais apparaîtront à la lecture de la description qui va suivre, en relation avec un exemple d'illustration de la présente invention donné à titre d'exemple non limitatif.

L'exemple de réalisation de l'invention concerne un dépôt par PVD, d'un alliage de composition (en poids) : 65 % de Co, 28 % de Cr, 5,5 % de Mo, les autres éléments étant inférieurs à 1 %, sur un substrat aluminium. Une face de ce dépôt a subi un traitement de surface mécanique, avant la réalisation d'essais, afin de la rendre similaire à d'autres surfaces de cuisson pour que les essais d'évaluation de la facilité à nettoyer une telle surface, dans une utilisation de cuisson domestique, puissent être comparés.

Le système d'évaluation de la facilité de nettoyage permet de quantifier les capacités d'une surface de cuisson à retrouver son aspect d'origine après usage. Ce système d'évaluation comprend les étapes suivantes :
- la surface est localement recouverte d'un mélange alimentaire de composition connue,
- ce mélange est carbonisé dans un four dans des conditions définies, par exemple 210 °C pendant 20 minutes,
- après refroidissement, la surface est mise à tremper pendant un temps contrôlé dans un mélange d'eau et de détergent,
- un tampon abrasif est ensuite appliqué sous une contrainte définie à l'aide d'un appareil à abraser (plynomètre) sur la surface souillée dans un mouvement de va-et-vient pendant un nombre donné de cycles,
- le pourcentage de la surface correctement nettoyée est noté et caractérise la facilité de nettoyage de la surface de cuisson.

Les essais menés sur différents types de surface permettent ainsi d'évaluer comparativement la qualité des surfaces quant à leur facilité de nettoyage.

Bien entendu, les essais sont réalisés en respectant les mêmes paramètres pour chaque étape du système d'évaluation : même mélange alimentaire, même surface d'application du mélange alimentaire, même température de carbonisation,...

Le tableau comparatif suivant montre les résultats obtenus sur trois surfaces de cuisson différentes, à savoir un inox poli, un quasi-cristaux, et l'alliage cobalt / chrome sur inox, tel que précédemment décrit, après polissage, dans un test sévère avec une composition alimentaire à base de lait et de riz réputée comme difficile à nettoyer une fois carbonisée. Un tel test permet ainsi de bien mettre en évidence les différences entre la qualité de nettoyage des surfaces.

| | Inox poli | Quasi-cristaux | Alliage Co/Cr poli sur Inox |
|---|---|---|---|
| Quantité de résidu carbonisé enlevée | 50 % | 60 % | 90 % |

Le tableau montre sans ambiguïté les résultats très intéressants obtenus avec l'alliage Co / Cr déposé sur inox et notamment les résultats comparés à d'autres surfaces de cuisson. D'autres tests conduits sur une base aluminium montrent des résultats analogues.

Il est à noter que le nombre de cycles d'abrasion sur le plynomètre a été fixé à 18. Ce nombre réduit de cycles met bien en évidence la qualité de facilité de nettoyage de la surface selon l'invention puisqu'il ne reste plus que 10 % de la surface souillée après 18 mouvements de va-et-vient du tampon abrasif.

Des essais répétitifs après nettoyage complet de la surface montrent que la facilité de nettoyage de l'alliage présenté n'est pas altérée.

Lorsque la mise en oeuvre de l'invention implique l'utilisation d'un substrat, celui-ci est alors composé d'une ou plusieurs tôle(s) métallique(s) des matériaux suivants : aluminium, inox, fonte, acier, cuivre.

## Revendications

1. Surface de cuisson d'aliment pour ustensile de cuisine ou appareil de cuisson, **caractérisée en ce que** cette surface de cuisson est un composé métallique contenant, en poids, au moins 50 % de cobalt et au moins 18 % de chrome.

2. Surface de cuisson d'aliment pour ustensile de cuisine ou appareil de cuisson selon la revendication précédente, **caractérisée en ce que** le composé métallique comporte au moins 5 % en poids d'un ou plusieurs des métaux parmi : tungstène, nickel, molybdène.

3. Surface de cuisson d'aliment pour ustensile de cuisine ou appareil de cuisson selon l'une des revendications précédentes, **caractérisée en ce que** le composé métallique comporte, en poids, au moins 60 % de cobalt, au moins 25 % de chrome et au moins 5 % de molybdène.

4. Surface de cuisson d'aliment pour ustensile de cuisine ou appareil de cuisson selon la revendication précédente, **caractérisée en ce que** le composé métallique comporte, en poids, 65 % de cobalt, 28 % de chrome, 5,5 % de molybdène, les autres éléments étant inférieurs à 1 %.

5. Surface de cuisson d'aliment pour ustensile de cuisine ou appareil de cuisson selon l'une des revendications précédentes, **caractérisée en ce qu'**elle est obtenue par le dépôt d'une épaisseur appropriée du matériau métallique sur un substrat.

6. Surface de cuisson d'aliment pour ustensile de cuisine ou appareil de cuisson selon la revendication 5, **caractérisée en ce que** le dépôt est réalisé par pulvérisation cathodique d'une cible massive.

7. Surface de cuisson d'aliment pour ustensile de cuisine ou appareil de cuisson selon la revendication 6, **caractérisée en ce que** la cible est obtenue par assemblage sur un substrat de cuivre d'une ou plusieurs tôles ou plaques de matériau ayant la composition recherchée, lesdites tôles ou plaques étant obtenues soit par frittage de poudre ou projection thermique de poudre, soit issues de coulée.

8. Surface de cuisson d'aliment pour ustensile de cuisine ou appareil de cuisson selon l'une des revendications 1 à 4, **caractérisée en ce qu'**elle est obtenue par assemblage d'une tôle métallique ayant la composition recherchée sur un substrat.

9. Surface de cuisson d'aliment pour ustensile de cuisine ou appareil de cuisson selon la revendication 8, **caractérisée en ce que** l'assemblage est réalisé par l'une des techniques suivantes : colaminage, brasage, frappe à chaud.

10. Surface de cuisson d'aliment pour ustensile de cuisine ou appareil de cuisson selon l'une des revendications 8 ou 9, **caractérisée en ce que** la tôle et le substrat subissent, après assemblage, une étape de mise en forme par emboutissage.

11. Surface de cuisson d'aliment pour ustensile de cuisine ou appareil de cuisson selon l'une des revendications 5 à 10, **caractérisée en ce que** le substrat est composé d'une ou plusieurs tôle(s) métallique(s) des matériaux suivants : aluminium, inox, fonte, acier, cuivre.

## Claims

1. A food-cooking surface for a kitchen utensil or a cooking appliance, the cooking surface being **characterized in that** it is a metal compound comprising, by weight, at least 50% cobalt and at least 18% chromium.

2. A food-cooking surface for a kitchen utensil or a cooking appliance according to the preceding claim, the surface being **characterized in that** the metal compound includes at least 5% by weight of one or more of the metals selected from: tungsten, nickel, and molybdenum.

3. A food-cooking surface for a kitchen utensil or a cooking appliance according to any preceding claim, **characterized in that** the metal compound comprises, by weight, at least 60% cobalt, at least 25% chromium, and at least 5% molybdenum.

4. A food-cooking surface for a kitchen utensil or a cooking appliance according to the preceding claim, **characterized in that** the metal compound comprises, by weight: 65% cobalt, 28% chromium, 5.5% molybdenum, with other elements being at less than 1 %,

5. A food-cooking surface for a kitchen utensil or a cooking appliance according to any preceding claim, **characterized in that** it is obtained by depositing an appropriate thickness of the metal material on a substrate.

6. A food-cooking surface for a kitchen utensil or a cooking appliance according to claim 5, **characterized in that** the deposit is made by cathode sputtering from a solid target.

7. A food-cooking surface for a kitchen utensil or a cooking appliance according to claim 6, **characterized in** at the target is obtained by assembling on a copper substrate one or more sheets or plates of material having the desired composition, said sheets or plates being obtained either by sintering a powder or by thermally projecting a powder, or being the result of casting.

8. A food-cooking surface for a kitchen utensil or a cooking appliance according to any one of claims 1 to 4, **characterized in that** it is obtained by assembling a metal sheet having the desired composition on a substrate.

9. A food-cooking surface for a kitchen utensil or a cooking appliance according to claim 8, **characterized in that** assembly is performed by one of the following techniques: roll bonding; brazing; and hot beating.

10. A food-cooking surface for a kitchen utensil or a cooking appliance according to claim 8 or claim 9, **characterized in that** the sheet and the substrate are subjected, after assembly, to a step of shaping by stamping.

11. A food-cooking surface for a kitchen utensil or a cooking appliance according to any one of claims 5 to 10, **characterized in that** the substrate is made up of one or more metal sheets of the following materials: aluminum; stainless steel; cast iron; steel; and copper.

## Patentansprüche

1. Fläche zum Kochen von Lebensmitteln für ein Küchenutensil oder Kochgerät, **dadurch gekennzeichnet, dass** diese Kochfläche eine Metallzusammensetzung ist, die einen Gewichtsanteil von mindestens 50 % Kobalt und mindestens 18 % Chrom enthält.

2. Fläche zum Kochen von Lebensmitteln für ein Küchenutensil oder Kochgerät nach dem vorangehenden Anspruch, **dadurch gekennzeichnet, dass** die Metallzusammensetzung einen Gewichtsanteil von mindestens 5 % eines oder mehrerer der folgenden Metallen enthält: Wolfram, Nickel, Molybdän.

3. Fläche zum Kochen von Lebensmitteln für ein Küchenutensil oder Kochgerät nach einem der vorangehenden Ansprüche, **dadurch gekennzeichnet, dass** die Metallzusammensetzung einen Gewichtsanteil von mindestens 60 % Kobalt, mindestens 25 % Chrom und mindestens 5 % Molybdän enthält.

4. Fläche zum Kochen von Lebensmitteln für ein Küchenutensil oder Kochgerät nach dem vorangehenden Anspruch, **dadurch gekennzeichnet, dass** die Zusammensetzung einen Gewichtsanteil von 65 % Kobalt, 28 % Chrom, 5,5 % Molybdän enthält, wobei die weiteren Bestandteile geringer als 1 % sind.

5. Fläche zum Kochen von Lebensmitteln für ein Küchenutensil oder Kochgerät nach dem vorangehenden Anspruch, **dadurch gekennzeichnet, dass** diese Fläche durch das Abscheiden des Metalls in einer geeigneten Dicke auf einem Substrat erhalten wird.

6. Fläche zum Kochen von Lebensmitteln für ein Küchenutensil oder Kochgerät nach Anspruch 5, **dadurch gekennzeichnet, dass** das Abscheiden durch Kathodenzerstäubung eines massiven Targets erfolgt.

7. Fläche zum Kochen von Lebensmitteln für ein Küchenutensil oder Kochgerät nach Anspruch 6, **dadurch gekennzeichnet, dass** das Target durch Zusammenfügen eines oder mehrerer Bleche oder Platten aus einem Material mit der gesuchten Zusammensetzung auf einem Kupfersubstrat erhalten wird, wobei die Bleche oder Platten entweder durch Sintern von Pulver oder thermisches Spritzen von Pulver oder als Gusserzeugnis erhalten werden.

8. Fläche zum Kochen von Lebensmitteln für ein Küchenutensil oder Kochgerät nach einem der Ansprüche 1 bis 4, **dadurch gekennzeichnet, dass** sie durch Zusammenfügen eines kristallinen Metallblechs mit der gesuchten Zusammensetzung auf einem Substrat erhalten wird.

9. Fläche zum Kochen von Lebensmitteln für ein Küchenutensil oder Kochgerät nach Anspruch 8, **dadurch gekennzeichnet, dass** das Zusammenfügen mittels einer der folgenden Techniken erfolgt: Paketwalzen, Löten, Warmschmieden.

10. Fläche zum Kochen von Lebensmitteln für ein Küchenutensil oder Kochgerät nach einem der Ansprüche 8 oder 9, **dadurch gekennzeichnet, dass** das Blech und das Substrat nach dem Zusammenfügen einem Formungsschritt durch Tiefziehen unterzogen werden.

11. Fläche zum Kochen von Lebensmitteln für ein Küchenutensil oder Kochgerät nach einem der Ansprüche 5 bis 10, **dadurch gekennzeichnet, dass** das Substrat aus einem oder mehreren Metallblechen aus folgenden Materialien besteht: Aluminium, nichtrostender Stahl, Gusseisen, Stahl, Kupfer.
